# FASCICULE DE BREVET EUROPEEN

(11) **EP 0 819 105 B1**
(45) Date de publication et mention de la délivrance du brevet: **22.10.2003**
(21) Numéro de dépôt: 96912082.3
(22) Date de dépôt: 09.04.1996
(51) Int. Cl.: C04B 35/83, C04B 35/80

(54) **PROCEDE D'INFILTRATION CHIMIQUE EN PHASE VAPEUR AVEC PARAMETRES D'INFILTRATION VARIABLES**
VERFAHREN ZUR CHEMISCHEN DAMPFINFILTRATION MIT VARIABLEN INFILTRATIONSPARAMETERN
CHEMICAL VAPOUR INFILTRATION METHOD WITH VARIABLE INFILTRATION PARAMETERS

(30) Priorité: 07.04.1995 FR 9504157
(43) Date de publication de la demande: 21.01.1998
(73) Titulaire: SOCIETE NATIONALE D'ETUDE ET DE CONSTRUCTION DE MOTEURS D'AVIATION, "S.N.E.C.M.A.", 75015 Paris (FR)
(72) Inventeur: LELUAN, Jean-Luc, F-33200 Bordeaux (FR); DOMBLIDES, Jean-Luc, F-33520 Bruges (FR); DELPERIER, Bernard, F-33127 Martignas-sur-Jalles (FR); THEBAULT, Jacques, F-33200 Bordeaux (FR); TOUSSAINT, Jean-Marie, F-33270 Bouliac (FR)
(74) Mandataire: Joly, Jean-Jacques
(86) Numéro de dépôt international: FR9600530
(87) Numéro de publication internationale: WO96031447

(56) Documents cités:
- US-A- 5 348 774

## Description

La présente invention concerne un procédé pour l'infiltration chimique en phase vapeur d'un matériau au sein d'un substrat poreux.

Un domaine d'application de l'invention est la réalisation de pièces en matériau composite comprenant un substrat de renfort fibreux, ou préforme, densifié par une matrice, en particulier des pièces en matériau composite carbone-carbone (préforme en fibres de carbone et matrice carbone) ou des pièces en matériau composite à matrice céramique (CMC).

Les matériaux composites carbone-carbone et les CMC sont utilisés dans différents domaines où sont exploitées leurs propriétés thermostructurales, c'est-à-dire de très bonnes propriétés mécaniques permettant de constituer des éléments de structure fortement sollicités et une capacité à conserver ces propriétés mécaniques jusqu'à des températures relativement élevées. Il en est ainsi par exemple dans le domaine spatial, notamment pour des panneaux de protection thermique ou des tuyères de propulseurs, dans le domaine aéronautique, par exemple pour des pièces de réacteurs d'avions, et dans le domaine de la friction, en particulier pour des disques de freins d'avions.

L'infiltration chimique en phase vapeur d'un matériau dans un substrat poreux consiste à disposer le substrat à l'intérieur d'une enceinte et à faire diffuser au sein de la porosité interne accessible du substrat une phase gazeuse contenant au moins un précurseur du matéziau à l'état gazeux tout en contrôlant en particulier la température et la pression dans l'enceinte pour que se forme un dépôt à partir du précurseur dans tout le volume du substrat. Le précurseur de carbone peut être un alcane, un alkyle, un alcène donnant du pyrocarbone par décomposition. Pour l'infiltration chimique en phase vapeur d'un matériau céramique, on fait diffuser une phase gazeuse contenant une ou plusieurs espèces gazeuses donnant le matériau céramique souhaité par décomposition ou par réaction chimique entre elles. Ainsi, par exemple, l'infiltration chimique en phase vapeur du carbure de silicium (SiC) peut être obtenue au moyen d'une phase gazeuse contenant du méthyltrichlorosilane (MTS) et en présence de gaz hydrogène (H₂). Des espèces gazeuses précurseurs d'autres céramiques telles que des carbures, nitrures ou oxydes sont bien connues de l'homme de l'art.

Il existe plusieurs procédés d'infiltration chimique en phase vapeur, notamment les procédés isothermes isobares et les procédés isobares à gradient de température.

Dans les procédés isothermes isobares, les substrats à densifier sont maintenus à chaque instant à une température uniforme dans tout leur volume et sous une pression uniforme. Un inconvénient de ce procédé réside dans l'impossibilité, en pratique, de réaliser une densification uniforme. En effet, le matériau de la matrice a tendance à se déposer de façon préférentielle au sein de la porosité proche de la surface extérieure du substrat. L'obstruction progressive de la porosité de surface rend l'accès de la phase gazeuse au sein du matériau de plus en plus difficile avec, pour résultat, un gradient de densification entre la surface et le coeur du matériau. Il peut certes être procédé une ou plusieurs fois à un usinage de surface ou écroûtage du substrat au cours du processus de densification afin de réouvrir la porosité de surface. Mais cela requiert l'interruption du processus pendant la durée nécessaire à l'extraction du substrat de l'installation de densification, son refroidissement, l'écroûtage, la réintroduction du substrat dans l'installation, et le retour à la température voulue.

Avec un type de procédé à gradient de température, il est permis dans une large mesure de limiter l'inconvénient précité du procédé isotherme. Une différence de température est établie entre une partie interne du substrat, plus chaude, et la surface du substrat exposée à la phase gazeuse. Le matériau de la matrice se dépose alors préférentiellement dans la partie interne plus chaude. En contrôlant la température de surface du substrat de sorte qu'elle soit inférieure au seuil de décomposition ou réaction de la phase gazeuse, au moins pendant une première partie du processus de densification, on peut faire en sorte que le front de densification progresse de l'intérieur vers la surface du substrat au fur et à mesure du déroulement du processus. De façon connue, le gradient de température peut être obtenu en plaçant un ou plusieurs substrats autour d'un suscepteur couplé à un inducteur avec une face interne du ou des substrats en contact avec le suscepteur. Il est possible étalement d'obtenir un gradient de température par couplage inductif direct avec le substrat en cours de densification, lorsque la nature de celui-ci le permet. Ces techniques sont décrites notamment dans les documents FR-A-2 711 647 et US-A-5 348 774. Dans ce dernier document, le chauffage des substrats est réalisé à la fois par couplage avec un suscepteur et par couplage direct avec les substrats au fur et à mesure de la progression du front de densification. Des moyens sont prévus pour mesurer la variation de poids des substrats de façon continue afin de surveiller l'évolution du processus de densification. En fonction de la variation de poids mesurée, le processus peut être optimisé, en particulier en ce qui concerne sa durée, par action sur des paramètres de densification, notamment la puissance fournie à l'inducteur. La surveillance de la variation de poids des substrats permet également de déterminer la fin du processus de densification. Le procédé à gradient de température permet certes d'obtenir une densification moins hétérogène, en comparaison avec le procédé isotherme, mais ne peut être mis en oeuvre qu'avec des substrats de forme particulière, notamment des substrats annulaires.

Quel que soit le procédé de densification utilisé, la microstructure du matériau déposé au sein du substrat dépend des conditions dans lesquelles l'infiltration chimique en phase vapeur est réalisée. Dans le cas par exemple du pyrocarbone, en modifiant ces conditions d'infiltration, on peut notamment obtenir un pyrocarbone de type laminaire lisse, laminaire sombre, laminaire rugueux ou isotrope. Or la microstructure du pyrocarbone est une caractéristique importante au regard des propriétés du substrat densifié. Ainsi, dans le cas de pièces en matériau composite carbone-carbone, on recherche souvent une microstructure de type laminaire rugueux, notamment en raison de sa faculté à être graphitée par traitement thermique. Le contrôle de la microstructure du matériau déposé au sein du substrat est également important pour un matériau de type céramique.

Dans le cas des procédés de densification isothermes, il a été constaté qu'en dépit d'une fixation initiale des paramètres de l'infiltration propre à donner un dépôt de microstructure souhaitée, cette dernière pouvait varier au cours du processus de densification. La difficulté de conserver une microstructure homogène est observée en particulier lors de la densification de substrats épais tels que des préformes fibreuses de plus de 5 cm d'épaisseur.

La présente invention a pour objet de remédier à cet inconvénient et de foumir un procédé d'infiltration chimique en phase vapeur permettant de densifier un substrat poreux par un matériau de microstructure contrôlée.

Ce but est atteint avec un procédé tel que défini dans la revendication 1.

Le précurseur désigne ici le constituant ou les constituants de la phase gazeuse qui, dans les conditions opératoires choisies, amène le dépôt du matériau souhaité au sein du substrat.

Dans le cas d'un dépôt de pyrocarbone, comme déjà indiqué, des précurseurs sont notamment des alcanes, des alkyles et des alcènes. Le dopant désigne ici le constituant ou les constituants de la phase gazeuse qui assure une fonction d'activation du dépôt carbone à partir du précurscur, dans les conditions opératoires choisies. Le dopant peut aussi constituer un précurseur. Ainsi, dans une phase gazeuse comprenant par exemple un mélange de méthane et de propane (tous deux précurseurs), le propane joue le rôle de dopant lorsque la température est d'environ 1000°C et la pression d'environ 1,3 kPa. D'autres dopants non nécessairement précurseurs peuvent être utilisés à la place ou avec du propane, jouant un rôle d'activateurs sur les gaz moins réactifs dans les conditions d'infiltration précitées (augmentation de la réactivité du méthane, par exemple). Pour des températures et pressions plus élevées, par exemple à une température d'environ 1100°C et une pression d'environ 6,5 kPa (50 Torr), le méthane joue le rôle de précurseur sans nécessiter la présence de dopant.

Par porométrie, on entend ici ce qui caractérise la porosité du substrat et plus particulièrement la forme de la porosité. Par exemple, il apparaîtra immédiatement à l'homme de l'art qu'un substrat fortement poreux, mais avec des pores faiblement communicants, peut poser sensiblement les mêmes problèmes de densification qu'un substrat faiblement poreux mais avec des pores largement communicants, les porométries étant alors considérées comme semblables.

Il est de pratique habituelle dans la technique de réaliser des processus d'infiltration chimique en phase vapeur avec des paramètres d'infiltration prédéterminés d'un bout à l'autre du processus indépendamment de la porométrie du substrat. Cest le cas notamment pour les procédés isothermes isobares. Les paramètres d'infiltration sont généralement choisis pour obtenir une densité finale désirée qui impose de poursuivre la densification autant que possible à la fin du processus vis-à-vis du besoin alors que la porométrie est la plus défavorable à une diffusion de la phase gazeuse au coeur du substrat.

Il a été constaté par la demanderesse, et ce de façon inattendue, qu'une infiltration chimique en phase vapeur réalisée avec un taux élevé de précurseur tout au long du processus d'infiltration, c'est-à-dire un taux bien plus important que celui utilisé habituellement, conduit à la formation d'un dépôt de microstructure constante. Toutefois, et notamment avec les procédés isothcrmes, il apparaît alors, et ceci n'est pas inattendu, un fort gradient de densification, la densification du substrat à coeur étant bien moins importante qu'au voisinage de la surface. Ce gradient de densification est d'autant plus marqué que la température d'infiltration est plus élevée.

Or, si une microstructure contrôlée du dépôt est nécessaire au regard des propriétés attendues du substrat densifié, il est tout aussi nécessaire à cette fin de minimiser l'hétérogénéité de densification entre le coeur et la surface du substrat.

L'adaptation progressive des paramètres d'infiltration tout au long du processus de densification, en fonction de l'évolution de la porométrie du substrat répond à ces exigences. Elle apporte en outre, par rapport aux procédés connus à paramètres fixes, un gain significatif en durée totale de densification.

La modification des conditions d'infiltration, lorsque l'on désire conserver une microtexture constante, est réalisée en faisant varier au moins le taux de précurseur et/ou de dopant, et ce d'une première valeur, au début du processus d'infiltration, à une deuxième valeur inférieure à la première, en fin du processus d'infiltration.

Le taux de précurseur principal et/ou de dopant est choisi au cours du processus à une valeur aussi élevée que possible. Ainsi, par exemple, dans le cas d'une densification isotherme par du pyrocarbone par infiltration chimique en phase vapeur à partir d'une phase gazeuse comprenant un mélange de méthane ou gaz naturel et de propane, le taux de propane, qui est à la fois précurseur principal et dopant, peut évoluer d'une valeur de préférence au moins égale à 20 %, qui est la valeur la plus élevée utilisée au début du processus, jusqu'à une valeur de préférence comprise entre 6 % et 20 % qui est la valeur la moins élevée utilisée en fin du processus. Le taux est ici mesuré en pourcentage en volume dans la phase gazeuse. Le choix d'une valeur supérieure à 35 %, pour le taux volumique de propane le plus élevé utilisé au début du processus, ne présente pas d'intérêt, la cinétique de dépôt ne s'en trouvant que très peu augmcntée.

D'autres paramètres peuvent être modifiés afin de conserver une microtexture constante, le taux de précurseur étant constant ou non. Il en est ainsi de la température et de la pression. Ainsi, toujours dans le cas d'une densification isotherme avec phase gazeuse comprenant un mélange de méthane, ou gaz naturel, et propane, et pour obtenir une microstructure de type laminaire rugueux, la température de densification peut être diminuée d'une première valeur, par exemple au moins égale à environ 1020°C jusqu'à une deuxième valeur, inférieure à la première et par exemple comprise environ entre 950°C et 1020°C, cette deuxième valeur étant choisie pour que la cinétique de dépôt ne soit pas trop lente, le seuil de température de dépôt étant dans cet exemple d'environ 860°C. Toujours dans le même exemple, la pression peut être diminuée d'une première valeur par exemple au moins égale à environ 2,5 kPa jusqu'à une deuxième valeur inférieure à la première et par exemple comprise environ entre 0,5 kPa et 2 kPa, puis réaugmentée à une troisième valeur par exemple supérieure à 3 kPa.

Il est possible aussi de modifier le temps de séjour de la phase gazeuse. Dans le cas où l'introduction de la phase gazeuse dans l'enceinte dans laquelle le substrat est placé et l'évacuation des gaz résiduels hors de cette enceinte sont réalisées de façon continue, le temps de séjour est compté comme le temps moyen d'écoulement des gaz entre l'accès à l'enceinte et la sortie de celle-ci, c'est-à-dire le temps de séjour dans la partie chaude de l'installation ; le temps de séjour dépend alors du débit de la phase gazeuse et du volume qu'elle peut occuper dans l'enceinte (fonction de la température, de la pression, du volume des substrats ...). Dans le cas où l'infiltration est réalisée de façon pulsée, c'est-à-dire par des cycles successifs comprenant chacun l'admission d'une quantité déterminée de phase gazeuse dans l'enceinte et l'évacuation des gaz résiduels par mise sous vide de l'enceinte, le temps de séjour est le temps qui s'écoule entre le début de l'admission et le début de l'évacuation. Si l'on fait varier le temps de séjour de la phase gazeuse au cours du processus d'infiltration, cette variation est dans le sens croissant.

La variation du ou des paramètres d'infiltration peut être réalisée de façon continue, tout au long du processus d'infiltration ou d'une partie de celui-ci, ou de façon discontinue.

Le processus d'infiltration peut être divisé en plusieurs phases successives séparées les unes des autres, de façon en soi connue, par une opération d'écroûtage qui, comme déjà indiqué, consiste à réaliser un usinage de surface pour éliminer un dépôt superficiel afin de réouvrir complètement l'accès de la phase gazeuse à la porosité interne du substrat. Dans ce cas, la modification des paramètres d'infiltration peut être réalisée de façon discontinue en définissant un nouvel ensemble de valeurs de paramètres pour une nouvelle phase de densification. Une modification des paramètres n'intervient pas nécessairement à chaque nouvelle phase.

On notera aussi que le contrôle de la microstructure du dépôt peut consister non seulement à maintenir une microstructure homogène dans toute la matrice déposée, ce qui sera le plus fréquemment recherché, mais aussi à faire varier la microstructure d'une façon prédéterminée au cours du processus de densification.

Le tableau ci-après indique des plages de valeurs des paramètres d'infiltration qui conviennent pour obtenir des pyrocarbones de type laminaire rugueux, de type laminaire sombre et de type laminaire lisse.

| Type de pyrocarbone | Taux de propane | Pression (kPa) | Température (°C) | Temps séjour (s) |
|---|---|---|---|---|
| Laminaire rugueux | >6% | > 0,5 | > 850 | ≥0,1 |
| | | ≤3,3 | ≤1050 | <10 |
| Lanunaire sombre | >6% | >3,3 | >800 | ≥0,1 |
| | | <100 | ≤1050 | <500 |
| Laminaire lisse | >6% | >0,5 | >1050 | ≥0,1 |
| | | ≤3,3 | <1250 | <10 |

Les conditions de dépôt indiquées dans le tableau ci-dessus pour du pyrocarbone de type laminaire lisse valent dans le cas de la densification isotherme. La conservation d'une microstructure laminaire lisse constante dans tout le dépôt pourra alors demander une variation d'un ou plusieurs paramètres dans les plages indiquées au cours du processus de densification.

Des exemples de mise en oeuvre du procédé selon l'invention seront maintenant décrits à titre indicatif mais non limitatif.

### Exemple 1

Un substrat poreux constitué par une préforme fibreuse en fibres de carbone est réalisé de la façon suivante. Des strates de tissu de 250 mm x 250 mm en fibres de polyacrylonitrile (PAN) préoxydé sont découpées et empilées en étant liées les unes aux autres par aiguilletage. L'aiguilletage est réalisé au fur et à mesure de la constitution de la préforme, chaque strate étant aiguilletée sur la structure sous-jacente en conservant une densité d'aiguilletage sensiblement uniforme dans toute la préforme, comme décrit notamment dans le document FR-A-2 584 106.

La préforme ainsi obtenue est soumise à un traitement thermique, pour transformer le PAN préoxydé en carbone, puis à une densification par infiltration chimique en phase vapeur en étant placée dans une chambre de réaction d'un four d'infiltration. Le processus d'infiltration, de type isotherme, est réalisé en quatre phases. A la fin de chaque phase et avant le début de la suivante, la préforme est retirée du four pour subir une opération d'écroûtage consistant à éliminer une accumulation de pyrocarbone à la surface de la préforme afin de réouvrir l'accès à la porosité interne de celle-ci et favoriser la poursuite de la densification.

La phase gazeuse admise dans la chambre de réaction est constituée par un mélange de gaz naturel (essentiellement du méthane) et de propane circulant de façon continue entre l'entrée et la sortie de la chambre. Le temps de séjour de la phase gazeuse dans la chambre est environ égal à 1 s, et la pression dans la chambre est maintenue à une valeur d'environ 1,3 kPa (10 Torr). Pendant chaque phase du processus d'infiltration la température est maintenue constante et égale à environ 980°C.

La modification des conditions d'infiltration porte uniquement sur le paramètre que constitue le taux de propane (précurseur principal du carbone et dopant) dans la phase gazeuse.

Le tableau ci-après indique, pour chacune des quatre phases I à IV du processus d'infiltration, la durée de la phase et le taux de propane en pourcentage en volume dans le mélange gaz naturel-propane.

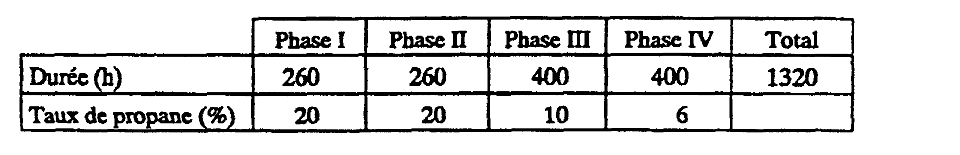

Le taux de propane est modifié de façon discontinue en passant de 20 % pendant la phase I à 6 % pendant la phase IV.

A la fin du processus d'infiltration, la prise de masse relative de la préforme, c'est-à-dire le rapport entre l'augmentation de sa masse et sa masse initiale, est de 220 %. L'examen d'une coupe effectuée dans la préforme densifiée montre une microstructure sensiblement homogène, de type laminaire rugueux jusqu'au coeur de la préforme.

### Exemple 2

On utilise une préforme identique à celle de l'exemple 1. L'infiltration par du pyrocarbone est réalisée également en quatre phases séparées par des écroûtages et en utilisant une phase gazeuse constituée d'un mélange de gaz naturel et de propane. Le temps de séjour de la phase gazeuse est d'environ 1 s, et la pression d'environ 1,3 kPa.

La modification des conditions d'infiltration porte ici sur deux paramètres : la température et le taux de propane et est réalisée de façon continue. Le tableau ci-après indique, pour chacune des phases I à IV du processus d'infiltration, la durée, la température au début de la phase, la température à la fin de la phase, le taux de propane au début de la phase et le taux de propane à la fin de la phase. On remarque que la température est modifiée de façon continue au cours seulement des phases I et II, tandis que le taux de propane est modifié de façon continue au cours seulement des phases III et IV. La variation de la température entre sa valeur la plus haute (1050°C) et sa valeur la plus basse (980°C) est réalisée de façon sensiblement linéaire. Il en est de même pour le taux de propane entre sa valeur la plus élevée (20 % en pourcentage volumique) et sa valeur la plus faible (10 %). On notera que le processus est de type isotherme, la température étant à chaque instant uniforme dans toute la préforme.

A la fin du processus d'infiltration, la prise de masse relative est d'environ 220 %. La densification jusqu'au coeur de la préforme présente sensiblement les mêmes caractéristiques que celles constatées dans l'exemple 1, mais la durée totale du processus de densification est nettement diminuée.

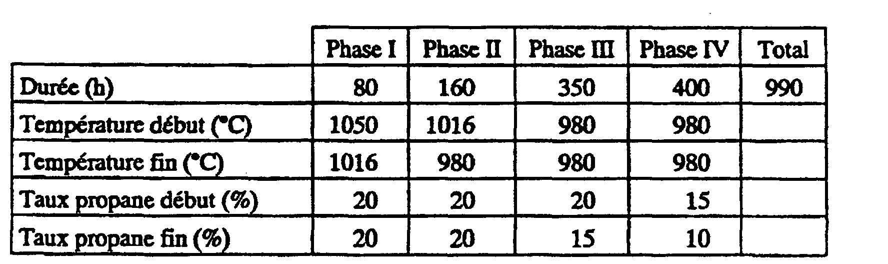

### Exemple 3 (exemple comparatif)

On utilise une préforme identique à celle de l'exemple 1. La densification par du pyrocabone est réalisée en quatre phases de durée respectivement égales à 500 h, 500 h, 400 b et 400 h séparées par des écroûtages. Les conditions d'infiltration sont maintenues inchangées pendant tout le processus d'infiltration, à savoir une phase gazeuse constituée d'un mélange de gaz naturel et de propane avec un taux volumique de propane de 6 %, une durée de séjour de la phase gazeuse d'environ 1,8 s, une pression de 1,5 kPa, et une température de 980°C.

Ces paramètres ainsi que les durées des phases d'infiltration ont des valeurs optimales telles que déterminées par la demanderesse pour la mise en oeuvre du processus d'infiltration chimique en phase vapeur classique, c'est-à-dire avec paramètres constants, permettant une densification similaire à celle obtenue avec les exemples 1 et 2. La prise de masse relative est la même (220 %) mais la microstructure du pyrocarbone n'est pas du tout homogène.

On constate l'avantage considérable apporté par la présente invention au plan industriel puisque la durée totale de densification est divisée par 1,36 (exemple 1) et par 1,82 (exemple 2) tout en aboutissant à un même résultat qu'avec le procédé de l'art antérieur en termes de degré de densification, mais en conservant une microstructure uniforme tout au long de l'infiltration.

### Exemple 4

Une préforme fibreuse en forme de disque de diamètre 250 mm et épaisseur 30 mm est réalisée par empilement et aiguilletage de strates de tissu, comme décrit dans l'exemple 1.

La préforme est densifiée par du pyrocarbone par infiltration chimique en phase vapeur à partir d'une phase gazeuse constituée par un mélange de gaz naturel et de propane, à une température de 1015°C et sous une pression de 1,5 kPa.

Le processus d'infiltration est réalisé en deux phases I et II séparées par une opération d'écroûtage. Le tableau ci-après donne, pour chacune des deux phases, la durée de la phase, le taux volumique de propane et le temps de séjour de la phase gazeuse.

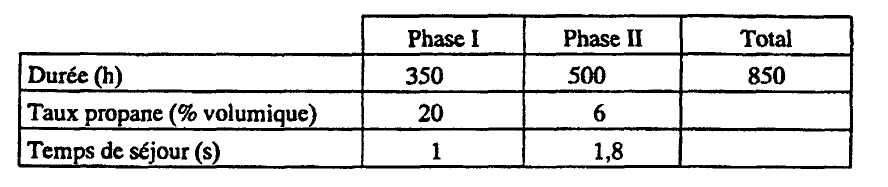

A la fin du processus d'infiltration, la prise de masse relative est de 250 % environ, la densification est sensiblement homogène et la microstructure du pyrocarbone, de type laminaire rugueux, est uniforme.

### Exemple 5

On utilise une préforme identique à celle de l'exemple 4. L'infiltration par du pyrocarbone est également réalisée en deux phases séparées par un écroûtage et en utilisant une phase gazeuse constituée par un mélange de gaz naturel et de propane, sous une pression de 1,5 kPa. Le tableau ci-après donne, pour chacune des deux phases, la durée de la phase, le taux volumique de propane (constant lors de chaque phase), les valeurs de début et de fin de la température (variation continue) et les valeurs de début et de fin du temps de séjour (variation continue).

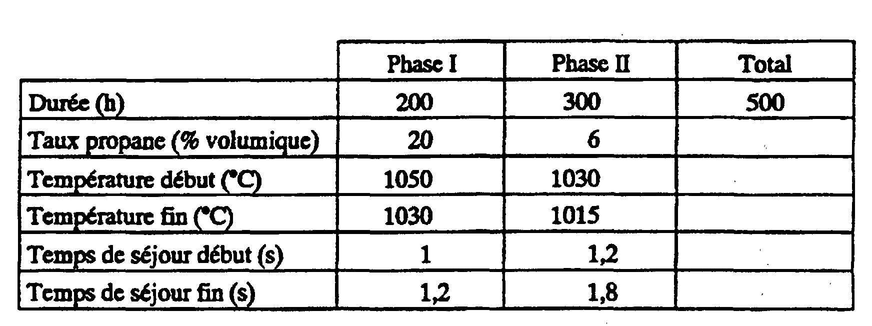

La prise de masse totale est de 250 %, la matrice de pyrocarbone présentant les mêmes caractéristiques que dans l'exemple 4.

### Exemple 6 (comparatif)

On utilise une préforme identique à celle de l'exemple 4. L'infiltration est réalisée en deux phases séparées par un écroûtage et en utilisant une phase gazeuse constituée par un mélange de gaz naturel et de propane. Les conditions d'infiltration sont maintenues de façon inchangée pendant tout le processus d'infiltration, à savoir un taux volumique de propane dans la phase gazeuse de 6 %, une température de 1015°C, un temps de séjour de 1,8 s et une pression de 1,5 kPa.

La durée de chaque phase est de 500 h pour arriver à une densification avec prise de masse de 250 %, comme dans les exemples 4 et 5.

Les exemples 4 et 5 démontrent que l'invention, tout en apportant une microstructure uniforme du pyrocarbone déposé, permet de réduire très sensiblement la durée totale de densification (division par 1,18 et par 2, en comparaison avec l'exemple 6).

### Exemple 7

Un substrat poreux constitué par une préforme fibreuse en fibres essentiellement de carbure de silicium (SiC) est réalisé en empilant des strates de tissu à armure toile dont les fils sont constitués de fibres commercialisées par la société japonaise Nippon Carbon sous la dénomination "Nicalon". Les strates de tissu sont empilées et comprimées dans un outillage pour obtenir une préforme avec un taux volumique de fibres de 35 % et une épaisseur de 5 mm.

La préforme est densifiée par du carbure de silicium obtenu par infiltration chimique en phase vapeur dans une chambre de réaction d'un four d'infiltration. Le processus d'infiltration de type isotherme est réalisé en trois phases I à III. A la fin de la première phase, la préforme est retirée du four pour démonter l'outillage, le dépôt de SiC étant suffisant pour assurer la consolidation de la préforme, c'est-à-dire pour lier les fibres entre elles de façon suffisante pour que la préforme conserve sa forme. Il n'est pas procédé à un écroûtage entre les phases de densification.

La phase gazeuse admise dans la chambre est constituée par un mélange de gaz méthyltrichlorosilane (MTS), préaustur de SiC et de gaz hydrogène (H₂). Le temps de séjour de la phase gazeuse dans la chambre est environ égal à 10 s, et la pression dans la chambre est maintenue à une valeur d'environ 13 kPa (100 Ton).

La modification des conditions d'infiltration porte uniquement sur la température. Le tableau ci-après indique, pour chacune des phases I à III, la durée de la phase, la température, celle-ci étant maintenue constante pendant chaque phase, et la densité de la préforme à la fin de chaque phase.

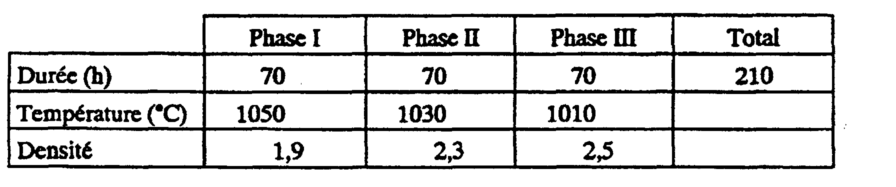

### Exemple 8 (comparatif)

On utilise une préforme identique à celle de l'exemple 7. L'infiltration par SiC est réalisée en deux phases I et II, une première phase de consolidation après laquelle la préforme est retirée de l'outillage et une deuxième phase pendant laquelle la densification est poursuivie jusqu'à atteindre un degré de densification sensiblement identique à celui atteint dans l'exemple 7.

La phase gazeuse utilisée et les conditions d'infiltration sont les mêmes que dans l'exemple 7 à l'exception de la température qui est maintenue constante pendant tout le processus, comme l'indique le tableau ci-après. Dans ce tableau sont indiquées également les durées des phases I et II la durée totale et les densités obtenues. On constate que, pour arriver à un même degré final de densification (densité 2,5), la durée totale du processus est sensiblement plus grande que celle de l'exemple 7, le gain sur cette durée totale apporté par la variation du paramètre température étant ici de 25 %.

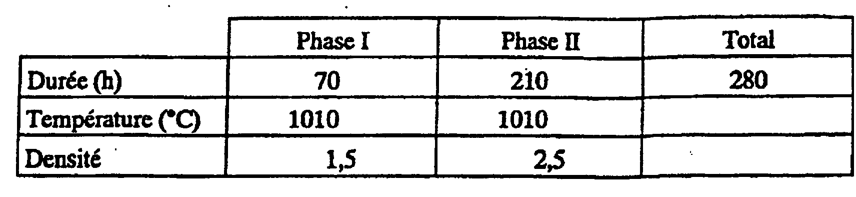

## Revendications

1. Procédé d'infiltration chimique en phase vapeur d'un matériau au sein d'un substrat poreux au moyen d'une phase gazeuse contenant au moins un précurseur dudit matériau à l'état gazeux, ledit procédé comprenant les étapes qui consistent à disposer le substrat à l'intérieur d'une enceinte, à introduire la phase gazeuse dans l'enceinte, à évacuer des gaz résiduels hors de l'enceinte et à modifier pendant le processus d'infiltration les conditions d'infiltration définies par un groupe de paramètres comportant : le temps de séjour de la phase gazeuse entre l'introduction dans l'enceinte et l'évacuation hors de l'enceinte, la pression dans l'enceinte, la température du substrat, la concentration en précurseur dans la phase gazeuse et la concentration en dopant éventuel dans la phase gazeuse,
**caractérisé en ce que** le procédé d'infiltration est de type isotherme et les conditions d'infiltration sont modifiées pendant le processus d'infiltration en faisant varier au moins l'un desdits paramètres entre une première valeur au début du processus d'infiltration et une deuxième valeur différente de la première, ledit temps de séjour étant, s'il est modifié, augmenté d'une première valeur à une deuxième valeur, ladite température étant, si elle est modifiée, diminuée d'une première valeur à une deuxième valeur, la concentration en précurseur étant, si elle est modifiée, diminuée d'une première valeur à une deuxième valeur, et la concentration en dopant éventuel étant, si elle est modifiée, diminuée d'une première valeur à une deuxième valeur,
de manière à adapter les conditions d'infiltration à l'évolution de la porométrie du substrat pour contrôler la microstructure du matériau déposé au sein du substrat.

2. Procédé selon la revendication 1, **caractérisé en ce que** ladite pression, si elle est modifiée, est diminuée d'une première valeur, au début du processus d'infiltration à une deuxième valeur inférieure à la première, au cours du processus d'infiltration, puis augmentée jusqu'à une troisième valeur supérieure à la deuxième, en fin de processus d'infiltration.

3. Procédé selon l'une quelconque des revendications 1 à 2, **caractérisé en ce que** la modification des conditions d'infiltration est réalisée de façon continue.

4. Procédé selon l'une quelconque des revendications 1 à 2, **caractérisé en ce que** la modification des conditions d'infiltration est réalisée de façon discontinue.

5. Procédé selon la revendication 4, dans lequel le processus d'infiltration chimique en phase vapeur est réalisé en plusieurs phases successives, **caractérisé en ce que** la ou chaque modification des conditions d'infiltration est réalisée au début d'une nouvelle phase.

6. Procédé selon l'une quelconque des revendications 1 à 5, pour l'infiltration chimique en phase vapeur de carbone pyrolytique au moyen d'une phase gazeuse contenant un mélange de méthane et de propane, **caractérisé en ce que** l'on fait varier le taux volumique de propane dans la phase gazeuse d'une valeur au moins égale à 20 % jusqu'à une valeur comprise entre 6 % et 20 %.

## Patentansprüche

1. Verfahren zur chemischen Infiltration in der Dampfphase eines Materials in das Innere eines porösen Substrats durch eine Gasphase, welche mindestens eine Vorstufe des Materials im gasförmigen Zustand enthält, wobei das Verfahren die Schritte aufweist, die bestehen aus dem Anordnen des Substrats im Inneren eines Behälters, dem Einbringen der Gasphase in den Behälter, dem Evakuieren von Restgasen aus dem Behälter und dem Modifizieren der Bedingungen der Infiltration während des Infiltrationsprozesses, definiert durch eine Gruppe von Parametern, aufweisend: Die Aufenthaltsdauer der Gasphase zwischen dem Einbringen in den Behälter und der Evakuierung aus dem Behälter, den Druck im Behälter, die Temperatur des Substrats, die Konzentration der Vorstufe in der Gasphase und die Konzentration einer etwaigen Dotierungssubstanz in der Gasphase,
**dadurch gekennzeichnet, dass**
das Verfahren der Infiltration vom isothermen Typ ist und die Bedingungen der Infiltration während des Infiltrationsprozesses modifiziert werden durch Variieren mindestens eines der genannten Parameter zwischen einem ersten Wert am Anfang des Infiltrationsprozesses und einem zweiten, vom ersten unterschiedlichen Wert, wobei die Aufenthaltsdauer, falls sie modifiziert wird, von einem ersten Wert auf einen zweiten Wert vergrößert wird, die Temperatur, falls sie modifiziert wird, von einem ersten Wert auf einen zweiten Wert verringert wird, die Konzentration der Vorstufe, falls sie modifiziert wird, von einem ersten Wert auf einen zweiten Wert verringert wird und die Konzentration der etwaigen Dotierungssubstanz, falls sie modifiziert wird, von einem ersten auf einen zweiten Wert verringert wird,
derart, dass die Bedingungen der Infiltration angepasst werden an die Entwicklung der Porometrie des Substrates, um die Mikrostruktur des Materials, das im Inneren des Substrats abgelagert wird, zu steuern.

2. Verfahren nach Anspruch 1, **dadurch gekennzeichnet dass** der Druck, falls er modifiziert wird, von einem ersten Wert am Beginn des Prozesses auf einen zweiten Wert, welcher geringer ist als der erste Wert, während des Infiltrationsprozesses verringert wird und anschließend bis zu einem dritten Wert, welcher höher ist als der zweite, am Ende des Infiltrationsprozesses vergrößert wird.

3. Verfahren nach einem der Ansprüche 1 und 2, **dadurch gekennzeichnet, dass** die Modifikation der Infiltrationsbedingungen kontinuierlich durchgeführt wird.

4. Verfahren nach einem der Ansprüche 1 und 2, **dadurch gekennzeichnet, dass** die Modifikation der Infiltrationsbedingungen diskontinuierlich durchgeführt wird.

5. Verfahren nach Anspruch 4, in welchem der chemische Infiltrationsprozess in der Dampfphase in mehreren aufeinanderfolgenden Phasen durchgeführt wird, **dadurch gekennzeichnet dass** jede Modifikation der Infiltrationsbedingungen am Beginn einer neuen Phase durchgeführt wird.

6. Verfahren nach einem der Ansprüche 1 bis 5, zur chemischen Infiltration in der Dampfphase von pyrolytischem Kohlenstoff durch eine Gasphase, welche eine Mischung aus Methan und Propan enthält, **dadurch gekennzeichnet, dass** der Volumenanteil des Propans in der Gasphase variiert wird von einem Wert von ca. 20 % bis zu einem Wert zwischen 6 % und 20 %.

## Claims

1. A chemical vapour infiltration method for infiltrating a material into a porous substrate by means of a gas containing at least one precursor of said material in the gaseous state, said method comprising the steps which consist in placing the substrate inside an enclosure, in introducing the gas into the enclosure, in exhausting residual gas from the enclosure and in modifying, during the infiltration process, the infiltration conditions as defined by a group of parameters including: the retention time of the gas between the introduction into the enclosure and the exhaustion from the enclosure, the pressure inside the enclosure, the temperature of the substrate, the concentration of the precursor in the gas, and the concentration of any dopant in the gas,
the method being **characterised in that** the infiltration process is of the isothermal type and the infiltration conditions are modified during the infiltration process by varying at least one of said infiltration parameters between a first value at the start of the infiltration process and a second value different from the first value, said retention time being, if modified, increased from a first value to a second value, said temperature being, if modified, decreased from a first value to a second value, the concentration of the precursor being, if modified, decreased from a first value to a second value, and the concentration of any dopant being, if modified, decreased from a first value to a second value,
thereby adapting infiltration conditions to changes in the porometry of the substrate to control the microstructure of the material deposited within the substrate.

2. A method according to claim 1, **characterized in that** said pressure, if modified, is decreased from a first value at the beginning of the infiltration process to a second value, lower than the first, during the infiltration process, and then increased to a third value, greater than the second, at the end of the infiltration process.

3. A method according to claim 1 or 2, **characterised in that** infiltration conditions are modified in continuous manner.

4. A method according to claim 1 or 2, **characterised in that** infiltration conditions are modified in discontinuous manner.

5. A method according to claim 4, in which the chemical vapour infiltration process is implemented in a plurality of successive stages, **characterised in that** the, or each, modification of infiltration conditions is implemented at the beginning of a new stage.

6. A method according to any one of claims 1 to 5, for chemical vapour infiltration of pyrolytic carbon by means of a gas containing a mixture of methane and propane, **characterised in that** the volume concentration of the propane is caused to vary in the gas from a value of not less than 20% to a value lying in the range 6% to 20%.
